# EUROPEAN PATENT SPECIFICATION

(11) **EP 3 901 824 B1**
(45) Date of publication and mention of the grant of the patent: **10.12.2025**
(21) Application number: 21179651.1
(22) Date of filing: 04.01.2016
(51) Int. Cl.: G06V 40/13

(54) **METHOD AND DEVICE FOR REALIZING TOUCH BUTTON AND FINGERPRINT IDENTIFICATION, AND TERMINAL DEVICE**
VERFAHREN UND VORRICHTUNG ZUR REALISIERUNG EINES BERÜHRUNGSKNOPFS UND FINGERABDRUCKERKENNUNG SOWIE ENDGERÄTEVORRICHTUNG
PROCÉDÉ ET DISPOSITIF PERMETTANT DE RÉALISER UNE IDENTIFICATION D'EMPREINTES DIGITALES ET DE BOUTON TACTILE ET DISPOSITIF TERMINAL

(30) Priority: 07.01.2015 CN 201510008243; 30.01.2015 CN 201510050761
(43) Date of publication of application: 27.10.2021
(62) Divisional of application: 16150089.7
(73) Proprietor: Xiaomi Inc., Beijing 100085 (CN)
(72) Inventor: JIANG, Zhongsheng, Haidian District 100085 (CN); YANG, Kun, Haidian District 100085 (CN); TAO, Jun, Haidian District 100085 (CN)
(74) Representative: Reddie & Grose LLP

(56) References cited:
- WO-A1-01/59558
- WO-A1-2014/143065
- AU-A4- 2013 100 571
- US-A- 4 290 052
- US-A1- 2010 156 595
- US-A1- 2014 341 447
- FENG TAO ET AL: "Touch panel with integrated fingerprint sensors based user identity management", 2013 IEEE INTERNATIONAL CONFERENCE ON TECHNOLOGIES FOR HOMELAND SECURITY (HST), IEEE, 12 November 2013 (2013-11-12), pages 154 - 160, XP032550157, DOI: 10.1109/THS.2013.6698992

## Description

### TECHNICAL FIELD

The present disclosure relates to the field of structural design of the terminal device, and more particularly, to a method and a device for realizing a touch button and fingerprint identification and a terminal device.

### BACKGROUND

With the increase of functions of the terminal device, more and more new functions of the terminal device bring more convenience to a user.

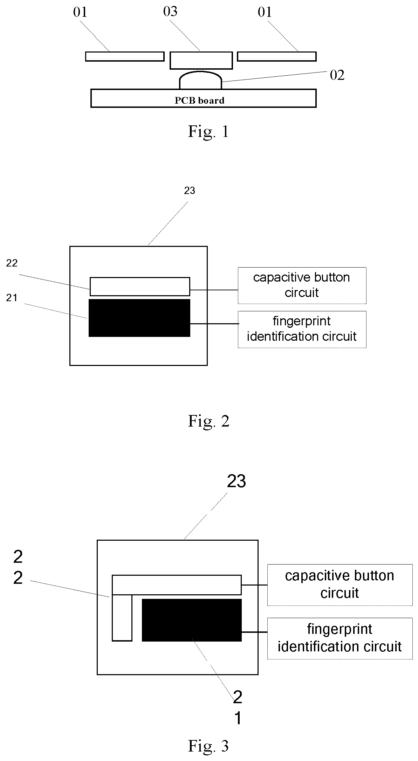

Presently, the fingerprint identification function begins to get the favor of major terminal device manufacturers. Concerning the design of the fingerprint identification function, known terminal devices (such as a mobile phone a tablet computer, etc.) basically combine the fingerprint identification function with a physical button, so as to achieve the purpose that the button may be compatible with the fingerprint identification, as a sectional view shown in Fig. 1. Usually, if adopting this design, the fingerprint identification area in the cover glass 01 is required to provide with a corresponding hole because the physical button 02 needs a fixed stroke when being pressed to enable the pressing to come into effect. If the user touches the fingerprint identification sensor 03 softly, the system may only identify this action as the fingerprint identification action; if the user presses the fingerprint identification sensor 03 and a certain stroke is reached, the physical button 02 may be triggered, so the system may identify this action as both the fingerprint identification action and the touch button action, and then the corresponding action may be extracted according to the requirements of upper layer. However, the structure described above not only affects the aesthetic appearance of the terminal device but also affects the convenience of the user's operation.

A relevant prior art is a document from FENG TAO ET AL, "Touch panel with integrated fingerprint sensors based user identity management", published in IEEE INTERNATIONAL CONFERENCE ON TECHNOLOGIES FOR HOMELAND SECURITY (HST), on 12 November 2013, which discloses an unified touch panel and fingerprint sensor where transparent capacitive TFT fingerprint sensors are being mounted on top of a touch screen at specific locations for user's identity verification.

### SUMMARY

In order to overcome problems existing in the related art, embodiments of the present disclosure provide a method and a device for realizing a touch button and fingerprint identification and a terminal device, which integrates the fingerprint identification and the touch button, thereby enhancing the aesthetic appearance of the terminal device, and improving the structural strength of the cover glass and the convenience of the user's operation.

According to a first aspect of embodiments of the present disclosure, there is provided a method for realizing a touch button and fingerprint identification, comprising:
a fingerprint identification sensor, disposed below a cover glass of a terminal device, the fingerprint identification sensor being configured to collect fingerprint information applied to the cover glass; and
a capacitive button sensor, disposed below the cover glass and located on at least one side of the fingerprint identification sensor, the capacitive button sensor being configured to collect button information applied to the cover glass based on a coupling capacitance formed between a finger of a user and a surface of the touch screen, wherein the coupling capacitance causes currents flowing through four electrodes at four corners of the touch screen, the currents flowing through the four electrodes being proportional to distances from the finger to the four corners, such that a location of a touch point of the finger is obtained by calculating ratios of the currents.

The capacitive button sensor is disposed close to the fingerprint identification sensor in a compact way without overlapping the fingerprint identification sensor, and the capacitive button sensor is located on one or more sides of the fingerprint identification sensor or surrounds the fingerprint identification sensor.

When a touch operation is applied to a preset touch area of the cover glass, the preset touch area covering at least a portion of the fingerprint identification sensor and at least a portion of the capacitive button sensor below the preset touch area, the fingerprint identification sensor and the capacitive button sensor collect the fingerprint information and the button information

In an embodiment, both the fingerprint identification sensor and the capacitive button sensor are located below a preset touch area of the cover glass.

According to a second aspect of embodiments of the present disclosure, there is provided a terminal device, comprising a device for realizing a touch button and fingerprint identification described above.

According to a third aspect of embodiments of the present disclosure, there is provided a method for realizing a touch button and fingerprint identification, comprising:
receiving a touch operation performed on a preset touch area of a cover glass of a touch screen, the preset touch area covering at least a portion of the fingerprint identification sensor and at least a portion of the capacitive button sensor below the preset touch area, wherein the fingerprint identification sensor is configured to collect fingerprint information applied to the cover glass, the capacitive button sensor is disposed close to the fingerprint identification sensor in a compact way without overlapping the fingerprint identification sensor, and the capacitive button sensor is located on one or more sides of the fingerprint identification sensor or surrounds the fingerprint identification sensor; and
collecting fingerprint information applied to the preset touch area; and
collecting a coupling capacitance formed between a finger of a user and a surface of the touch screen and collecting button information applied to the cover glass based on the coupling capacitance; wherein the coupling capacitance causes currents flowing through four electrodes at four corners of the touch screen, the currents flowing through the four electrodes being proportional to distances from the finger to the four corners, such that a location of a touch point of the finger is obtained by calculating ratios of the currents;
wherein the collecting by the fingerprint identification sensor and the collecting by the capacitive button sensor are performed.

In an embodiment, collecting fingerprint information applied to the preset touch area; and/or collecting a capacitance generated on the cover glass and analyzing the capacitance to obtain a capacitance variation comprises:
collecting the fingerprint information applied to the preset touch area, if an upper application sends out a fingerprint information collecting instruction;
collecting the capacitance generated on the cover glass and analyzing the capacitance to obtain the capacitance variation, if the upper application sends out a button information collecting instruction;
collecting the fingerprint information applied to the preset touch area, and collecting the capacitance generated on the cover glass and analyzing the capacitance to obtain the capacitance variation, if the upper application sends out the fingerprint information collecting instruction and the button information collecting instruction.

According to a fourth aspect of embodiments of the present disclosure, there is provided a device for realizing a touch button and fingerprint identification, comprising:
a processor;
a memory for storing instructions executable by the processor;
in which the processor is configured to:
   receive a touch operation performed on a preset touch area of a cover glass of a touch screen, the preset touch area covering at least a portion of a fingerprint identification sensor and at least a portion of a capacitive button sensor below the preset touch area, wherein the fingerprint identification is configured to collect fingerprint information applied to the cover glass, the capacitive button sensor is disposed close to the fingerprint identification sensor in a compact way without overlapping the fingerprint identification sensor, and the capacitive button sensor is located on one or more sides of the fingerprint identification sensor or surrounds the fingerprint identification sensor; and
   collect fingerprint information applied to the preset touch area; and
   collect a coupling capacitance formed between a finger of a user and a surface of the touch screen and collecting button information applied to the cover glass based on the coupling capacitance; wherein the coupling capacitance causes currents flowing through four electrodes at four corners of the touch screen, the currents flowing through the four electrodes being proportional to distances from the finger to the four corners, such that a location of a touch point of the finger is obtained by calculating ratios of the currents,
   wherein the collecting by the fingerprint identification sensor and the collecting by the capacitive button sensor are performed.

As such, the processor is configured to carry out the method as described herein.

The technical solutions provided in embodiments of the present disclosure may have advantageous effects as follows.

With the device for realizing a touch button and fingerprint identification in the technical solutions described above, when using the device, the user only needs to touch and press the preset touch area of the cover glass via the finger with any strength, then both the touch button information and the fingerprint information may be read by the device. In this way, the current user's identity may be identified. In addition, the fingerprint identification and the touch button are integrated, so as to realize the compatibility mode, thereby not only enhancing the aesthetic appearance of the terminal device but also improving the structural strength of the cover glass. Moreover, the user only needs to perform the simple touch and press operations on the cover glass with any strength, which is convenient for the user to operate.

It is to be understood that both the foregoing general description and the following detailed description are exemplary and explanatory only and are not restrictive of the invention, as claimed.

### BRIEF DESCRIPTION OF THE DRAWINGS

The accompanying drawings, which are incorporated in and constitute a part of this specification, illustrate embodiments consistent with the invention and, together with the description, serve to explain the principles of the invention.
Fig. 1 is a sectional view showing a structure of a touch button of a terminal device in the related art;
Fig. 2 is a sectional view showing a structure of a device for realizing a touch button and fingerprint identification according to an example embodiment;
Fig. 3 is a sectional view showing a structure of a device for realizing a touch button and fingerprint identification according to an example embodiment;
Fig. 4 is a sectional view showing a structure of another device for realizing a touch button and fingerprint identification according to an example embodiment;
Fig. 5 is a sectional view showing a structure of another device for realizing a touch button and fingerprint identification according to an example embodiment;
Fig. 6 is a flow chart showing a method for realizing a touch button and fingerprint identification according to an example embodiment;
Fig. 7 is a flow chart showing step S602 in a method for realizing a touch button and fingerprint identification according to an example embodiment;
Fig. 8 is a block diagram showing a device for realizing a touch button and fingerprint identification according to an example embodiment.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

A device for realizing a touch button and fingerprint identification is provided in embodiments of the present disclosure. As shown in Fig. 2, the device includes a fingerprint identification sensor 21 and a capacitive button sensor 22.

The fingerprint identification sensor 21 is disposed below a cover glass 23 of a terminal device.

The capacitive button sensor 22 is disposed below the cover glass 23 and located on at least one side of the fingerprint identification sensor 21.

In an embodiment, the fingerprint identification sensor 21 and the capacitive button sensor 22 are located below a preset touch area of the cover glass 23.

In an embodiment, the capacitive button sensor 22 is located on at least one side of the fingerprint identification sensor 21, which may be implemented as follows.

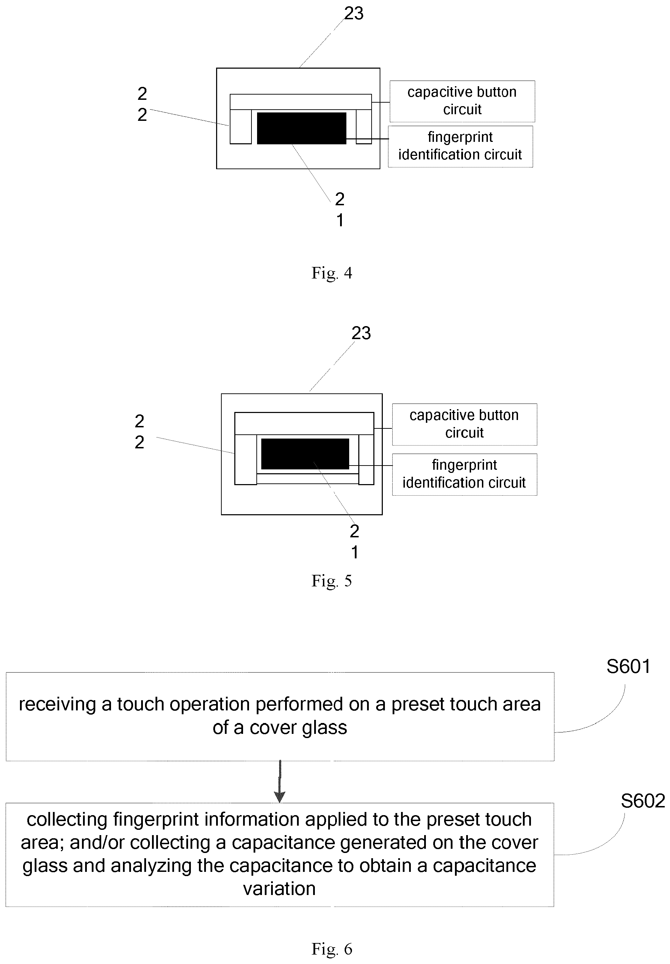

The capacitive button sensor 22 is located on any one or more sides of the fingerprint identification sensor 21; or the capacitive button sensor 22 surrounds the fingerprint identification sensor 21. In order to ensure the effect of the integration of the fingerprint identification and the capacitive button, and to cover both at least part of the capacitive button sensor and at least part of the fingerprint identification sensor below the preset touch area when the user's finger touches and presses the preset touch area of the cover glass, it is necessary to dispose the capacitive button sensor and the fingerprint identification sensor in a compact way. The capacitive button sensor is disposed close to the fingerprint identification sensor and the capacitive button sensor is disposed at two or more sides of the fingerprint identification sensor or surrounding the fingerprint identification sensor, as shown in Figs. 3, 4 and 5. In Figs. 3 and 4, the capacitive button sensor 22 is disposed at multiple sides of the fingerprint identification sensor 21. In Fig. 5, the capacitive button sensor 22 is disposed to surround the fingerprint identification sensor 21. Therefore, the effect of the integration of the fingerprint identification and the capacitive button may be ensured.

The fingerprint identification sensor 21 is configured to collect fingerprint information applied to the cover glass 23. The capacitive button sensor 22 is configured to collect button information applied to the cover glass 23. The working principle of the capacitive button sensor 22 is that, when the finger touches the metal layer of the capacitive button sensor 22, a coupling capacitance may be formed between the user and the surface of the touch screen because of the electric field of the human body. For the high frequency current, the capacitance is the direct conductor, so the finger may take a small current from the touch point. The currents flow from electrodes at four corners of the touch screen respectively, and the currents flowing through these four electrodes are respectively proportional to the distances from the finger to four corners. The controller calculates ratios of the four currents precisely and then obtains the location of the touch point.

The working principle of the terminal device described above is explained as follow.

When the user touches and presses the preset touch area of the cover glass 23 via the finger, the fingerprint identification sensor 21 may collect the fingerprint information applied to the surface of the cover glass 23 and send the fingerprint information to the fingerprint identification circuit. The fingerprint identification circuit may analyze and process the fingerprint information collected by the fingerprint identification sensor 21 to obtain the fingerprint analysis results such as fingerprint texture, fingerprint spacing and other fingerprint characteristic information. Meanwhile, the capacitive button sensor 22 may collect the button information applied to the surface of the cover glass 23 and send the button information to the capacitive button circuit. The capacitive button circuit may analyze and process the button information collected by the capacitive button sensor 22 to obtain the user's operation of touching the button. Then the processor of the host may perform the identity authentication according to the operation of touching the button and the fingerprint analysis results, for example, the fingerprint analysis results obtained by the fingerprint identification circuit may be compared with the pre-stored fingerprint data to determine the identity of the current user.

A terminal device is also provided in embodiments of the present disclosure, which incudes the device for realizing a touch button and fingerprint identification described above.

In summary, with the device for realizing a touch button and fingerprint identification in the embodiments of the present disclosure, when using the device, the user only needs to touch and press the preset touch area of the cover glass via the finger with any strength, then both the touch button information and the fingerprint information may be read by the device. In this way, the current user's identity may be identified. In addition, the fingerprint identification and the touch button are integrated, so as to realize the compatibility mode, thereby not only enhancing the aesthetic appearance of the terminal device but also improving the structural strength of the cover glass. Moreover, the user only needs to perform the simple touch and press operations on the cover glass with any strength, which is convenient for the user to operate.

Fig. 6 is a flow chart showing a method for realizing a touch button and fingerprint identification according to an example embodiment, which is applies in a terminal with the fingerprint identification function. As shown in Fig. 6, the method includes following steps S601-S602.

In step S601, a touch operation performed on a preset touch area of a cover glass is received.

The fingerprint identification sensor 21 and the capacitive button sensor 22 shown in Fig. 2 are disposed below the preset touch area.

In step S602, fingerprint information applied to the preset touch area is collected; and/or a capacitance generated on the cover glass is collected and the capacitance is analyzed to obtain a capacitance variation.

After obtaining the capacitance variation, the button information may be obtained according to the capacitance variation.

In summary, with the method for realizing a touch button and fingerprint identification in the embodiments of the present disclosure, when using the terminal, the user only needs to touch and press the preset touch area of the cover glass via the finger with any strength, both the touch button information and the fingerprint information may be read. In this way, the current user's identity may be identified. In addition, the fingerprint identification and the touch button are integrated, so as to realize the compatibility mode, thereby not only enhancing the aesthetic appearance of the terminal device but also improving the structural strength of the cover glass. Moreover, the user only needs to perform the simple touch and press operations on the cover glass with any strength, which is convenient for the user to operate.

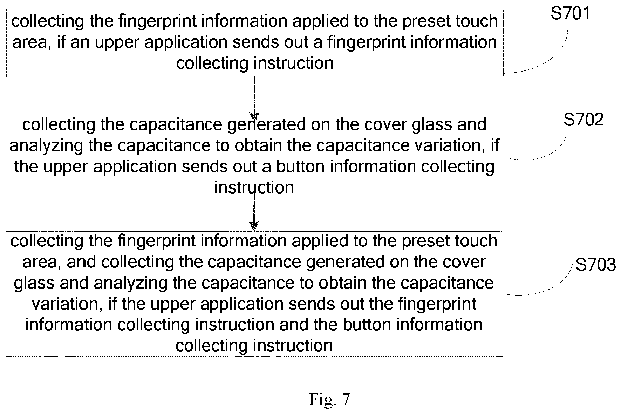

In an embodiment, as shown in Fig. 7, step S602 may be implemented by steps S701-S703.

In step S701, the fingerprint information applied to the preset touch area is collected, if an upper application sends out a fingerprint information collecting instruction.

In step S702, the capacitance generated on the cover glass is collected and the capacitance is analyzed to obtain the capacitance variation, if the upper application sends out a button information collecting instruction.

In step S703, the fingerprint information applied to the preset touch area is collected, and the capacitance generated on the cover glass is collected and the capacitance is analyzed to obtain the capacitance variation, if the upper application sends out the fingerprint information collecting instruction and the button information collecting instruction.

In the method described above, when the user touches the preset touch area, the fingerprint information may be collected and the button information may be read according to the collecting instructions on the actual requirements of the upper application, without interfering with each other.

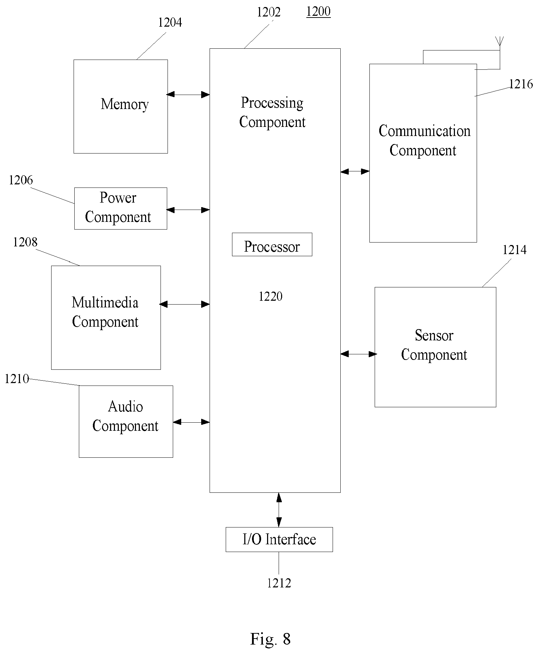

Fig. 8 is a block diagram showing a device 1200 for realizing a touch button and fingerprint identification according to an example embodiment and this device 1200 is suitable to terminal devices. For example, the device 1200 may be a mobile phone, a computer, a digital broadcast terminal, a messaging device, a gaming console, a tablet, a medical device, exercise equipment, a personal digital assistant, and the like.

Referring to Fig. 8, the device 1200 may include one or more of the following components: a processing component 1202, a memory 1204, a power component 1206, a multimedia component 1208, an audio component 1210, an input/output (I/O) interface 1212, a sensor component 1214 and a communication component 1216.

The processing component 1202 typically controls overall operations of the device 1200, such as the operations associated with display, telephone calls, data communications, camera operations, and recording operations. The processing component 1202 may include one or more processors 1220 to execute instructions so as to perform all or a part of the steps in the above described methods. Moreover, the processing component 1202 may include one or more modules which facilitate the interaction between the processing component 1202 and other components. For instance, the processing component 1202 may include a multimedia module to facilitate the interaction between the multimedia component 1208 and the processing component 1202.

The memory 1204 is configured to store various types of data to support the operation of the device 1200. Examples of such data include instructions for any applications or methods operated on the device 1200, contact data, phonebook data, messages, pictures, videos, etc. The memory 1204 may be implemented using any type of volatile or non-volatile memory devices, or a combination thereof, such as a static random access memory (SRAM), an electrically erasable programmable read-only memory (EEPROM), an erasable programmable read-only memory (EPROM), a programmable read-only memory (PROM), a read-only memory (ROM), a magnetic memory, a flash memory, a magnetic or optical disk.

The power component 1206 is configured to provide power to various components of the device 1200. The power component 1206 may include a power management system, one or more power sources, and other components associated with the generation, control, and distribution of power in the device 1200.

The multimedia component 1208 includes a screen configured to provide an output interface between the device 1200 and the user. In some embodiments, the screen may include a liquid crystal display (LCD) and a touch panel (TP). If the screen includes the touch panel, the screen may be implemented as a touch screen to receive input signals from the user. The touch panel includes one or more touch sensors to sense touches, swipes, and gestures on the touch panel. The touch sensors may not only sense a boundary of a touch or swipe action, but also sense a period of time and a pressure associated with the touch or swipe action. In some embodiments, the multimedia component 1208 includes a front camera and/or a rear camera. The front camera and the rear camera may receive an external multimedia datum when the device 1200 is in an operation mode such as a photographing mode or a video mode. Each of the front camera and the rear camera may be a fixed optical lens system or have focus and optical zoom capability.

The audio component 1210 is configured to output and/or input audio signals. For example, the audio component 1210 includes a microphone ("MIC") configured to receive an external audio signal when the device 1200 is in an operation mode, such as a call mode, a recording mode, and a voice recognition mode. The received audio signal may be further stored in the memory 1204 or transmitted via the communication component 1216. In some embodiments, the audio component 1210 further includes a loud speaker to output audio signals.

The I/O interface 1212 is configured to provide an interface between the processing component 1202 and peripheral interface modules, such as a keyboard, a click wheel, buttons, and the like. The buttons may include, but are not limited to, a home button, a volume button, a starting button, and a locking button.

The sensor component 1214 includes one or more sensors to provide status assessments of various aspects of the device 1200. For instance, the sensor component 1214 may detect an on/off status of the device 1200, relative positioning of components (e.g., a display screen and a keypad) of the device 1200. The sensor component 1214 may further detect a change in position of the device 1200 or a component of the device 1200, a presence or absence of user contact with the device 1200, an orientation or an acceleration/deceleration of the device 1200, and a change in temperature of the device 1200. The sensor component 1214 may include a proximity sensor configured to detect the presence of nearby objects without any physical contact. The sensor component 1214 may further include a light sensor, such as a CMOS or CCD image sensor, for use in imaging applications. In some embodiments, the sensor component 1214 may also include an accelerometer sensor, a gyroscope sensor, a magnetic sensor, a pressure sensor, or a temperature sensor.

The communication component 1216 is configured to facilitate a wired or wireless communication between the device 1200 and other terminals. The device 1200 can access a wireless network based on a communication standard, such as WiFi, 2G, or 3G, or a combination thereof. In one example embodiment, the communication component 1216 receives a broadcast signal or broadcast associated information from an external broadcast control system via a broadcast channel. In one example embodiment, the communication component 1216 further includes a near field communication (NFC) module to facilitate short-range communications. For example, the NFC module may be implemented based on a radio frequency identification (RFID) technology, an infrared data association (IrDA) technology, an ultra-wideband (UWB) technology, a Bluetooth (BT) technology, or other technologies.

In example embodiments, the device 1200 may be implemented with one or more electronic elements such as application specific integrated circuits (ASICs), digital signal processors (DSPs), digital signal processing devices (DSPDs), programmable logic devices (PLDs), field programmable gate arrays (FPGAs), controllers, micro-controllers, microprocessors, or other electronic components, for performing the above described methods.

In example embodiments, there is further provided a non-transitory computer readable storage medium including instructions, such as the memory 1204 including instructions executable by the processor 1220 in the device 1200 to perform the above-described methods. For example, the non-transitory computer-readable storage medium may be a ROM, a RAM, a CD-ROM, a magnetic tape, a floppy disc, an optical data storage device, and the like.

A device for realizing a touch button and fingerprint identification, includes:
a processor; and
a memory for storing instructions executable by the processor a processor; and
in which the processor is configured to:
   receive a touch operation performed on a preset touch area of a cover glass;
   collect fingerprint information applied to the preset touch area; and/or collect a capacitance generated on the cover glass and analyze the capacitance to obtain a capacitance variation.

The processor is further configured to:
collect the fingerprint information applied to the preset touch area, if an upper application sends out a fingerprint information collecting instruction;
collect the capacitance generated on the cover glass and analyze the capacitance to obtain the capacitance variation, if the upper application sends out a button information collecting instruction;
collect the fingerprint information applied to the preset touch area, and collect the capacitance generated on the cover glass and analyze the capacitance to obtain the capacitance variation, if the upper application sends out the fingerprint information collecting instruction and the button information collecting instruction.

A non-transitory computer readable storage medium, when executed by a processor of a mobile terminal, causes the mobile terminal to execute a method for realizing a touch button and fingerprint identification including:
receiving a touch operation performed on a preset touch area of a cover glass;
collecting fingerprint information applied to the preset touch area; and/or collecting a capacitance generated on the cover glass and analyzing the capacitance to obtain a capacitance variation.

Collecting fingerprint information applied to the preset touch area; and/or collecting a capacitance generated on the cover glass and analyzing the capacitance to obtain a capacitance variation includes:
collecting the fingerprint information applied to the preset touch area, if an upper application sends out a fingerprint information collecting instruction;
collecting the capacitance generated on the cover glass and analyzing the capacitance to obtain the capacitance variation, if the upper application sends out a button information collecting instruction;
collecting the fingerprint information applied to the preset touch area, and collecting the capacitance generated on the cover glass and analyzing the capacitance to obtain the capacitance variation, if the upper application sends out the fingerprint information collecting instruction and the button information collecting instruction

Other embodiments of the invention will be apparent to those skilled in the art from consideration of the specification and practice of the invention disclosed here.

## Claims

1. A device for realizing an integrated touch button and fingerprint identification, comprising:
a fingerprint identification sensor (21), disposed below a cover glass (23) of a touch screen of a terminal device, the fingerprint identification sensor being configured to collect fingerprint information applied to the cover glass; and
a capacitive button sensor (22), disposed below the cover glass (23) and located on at least one side of the fingerprint identification sensor (21), the capacitive button sensor being configured to collect button information applied to the cover glass (23) based on a coupling capacitance formed between a finger of a user and a surface of the touch screen, wherein the coupling capacitance causes currents flowing through four electrodes at four corners of the touch screen, the currents flowing through the four electrodes being proportional to distances from the finger to the four corners, such that a location of a touch point of the finger is obtained by calculating ratios of the currents;
wherein the capacitive button sensor (22) is disposed close to the fingerprint identification sensor (21) in a compact way without overlapping the fingerprint identification sensor (21), and the capacitive button sensor (22) is located on one or more sides of the fingerprint identification sensor (21) or surrounds the fingerprint identification sensor (21);
wherein when a touch operation is applied to a preset touch area of the cover glass (23), the preset touch area covering at least a portion of the fingerprint identification sensor (21) and at least a portion of the capacitive button sensor (22) below the preset touch area, the fingerprint identification sensor (21) and the capacitive button sensor (22) collect the fingerprint information and the button information.

2. The device according to claim 1, wherein both the fingerprint identification sensor (21) and the capacitive button sensor (22) are located below the preset touch area of the cover glass (23).

3. A terminal device, comprising a device for realizing a touch button and a fingerprint identification according to any one of claims 1-2.

4. A method for realizing a touch button and a fingerprint identification, comprising:
receiving (S601) a touch operation performed on a preset touch area of a cover glass of a touch screen, the preset touch area covering at least a portion of the fingerprint identification sensor (21) and at least a portion of the capacitive button sensor (22) below the preset touch area, wherein the fingerprint identification sensor is configured to collect fingerprint information applied to the cover glass, the capacitive button sensor (22) is disposed close to the fingerprint identification sensor (21) in a compact way without overlapping the fingerprint identification sensor (21), and the capacitive button sensor (22) is located on one or more sides of the fingerprint identification sensor (21) or surrounds the fingerprint identification sensor (21); and
collecting (S602) fingerprint information applied to the preset touch area; and collecting a coupling capacitance formed between a finger of a user and a surface of the touch screen and collecting button information applied to the cover glass (23) based on the coupling capacitance; wherein the coupling capacitance causes currents flowing through four electrodes at four corners of the touch screen, the currents flowing through the four electrodes being proportional to distances from the finger to the four corners, such that a location of a touch point of the finger is obtained by calculating ratios of the currents;
wherein the collecting by the fingerprint identification sensor and the collecting by the capacitive button sensor are performed.

5. The method according to claim 4, wherein collecting (S602) fingerprint information applied to the preset touch area; and/or collecting a capacitance generated on the cover glass and analyzing the capacitance to obtain a capacitance variation comprises:
collecting (S701) the fingerprint information applied to the preset touch area, if an upper application sends out a fingerprint information collecting instruction;
collecting (S702) the capacitance generated on the cover glass and analyzing the capacitance to obtain the capacitance variation, if the upper application sends out a button information collecting instruction;
collecting (S703) the fingerprint information applied to the preset touch area, and collecting the capacitance generated on the cover glass and analyzing the capacitance to obtain the capacitance variation, if the upper application sends out the fingerprint information collecting instruction and the button information collecting instruction.

6. A device for realizing a touch button and a fingerprint identification, comprising:
a processor; and
a memory for storing instructions executable by the processor;
wherein the processor is configured to:
receive (S601) a touch operation performed on a preset touch area of a cover glass of a touch screen, the preset touch area covering at least a portion of the fingerprint identification sensor (21) and at least a portion of the capacitive button sensor (22) below the preset touch area, wherein the fingerprint identification is configured to collect fingerprint information applied to the cover glass, the capacitive button sensor (22) is disposed close to the fingerprint identification sensor (21) in a compact way without overlapping the fingerprint identification sensor (21), and the capacitive button sensor (22) is located on one or more sides of the fingerprint identification sensor (21) or surrounds the fingerprint identification sensor (21); and
collect (S602) fingerprint information applied to the preset touch area; and collect a coupling capacitance formed between a finger of a user and a surface of the touch screen and collecting button information applied to the cover glass (23) based on the coupling capacitance; wherein the coupling capacitance causes currents flowing through four electrodes at four corners of the touch screen, the currents flowing through the four electrodes being proportional to distances from the finger to the four corners, such that a location of a touch point of the finger is obtained by calculating ratios of the currents;
wherein the collecting by the fingerprint identification sensor and the collecting by the capacitive button sensor are performed.

7. A non-transitory computer readable storage medium, when executed by a processor of a mobile terminal, causes the mobile terminal to execute a method for realizing a touch button and a fingerprint identification according to claim 4 or 5.

## Patentansprüche

1. Vorrichtung zur Realisierung einer integrierten Berührtaste und Fingerabdruckidentifizierung, die Folgendes beinhaltet:
einen Fingerabdruckidentifizierungssensor (21), der unter einem Deckglas (23) eines Berührbildschirms einer Endgerätvorrichtung angeordnet ist, wobei der
Fingerabdruckidentifizierungssensor zum Erfassen von auf das Deckglas aufgebrachten Fingerabdruckinformationen konfiguriert ist; und
einen kapazitiven Tastensensor (22), der unter dem Deckglas (23) angeordnet ist und auf mindestens einer Seite des Fingerabdruckidentifizierungssensors (21) liegt, wobei der kapazitive Tastensensor zum Erfassen von auf das Deckglas (23) aufgebrachten Tasteninformationen auf Basis einer zwischen einem Finger eines Benutzers und einer Oberfläche des Berührbildschirms gebildeten Kopplungskapazität konfiguriert ist, wobei die Kopplungskapazität durch vier Elektroden an vier Ecken des Berührbildschirms fließende Ströme verursacht, wobei die durch die vier Elektroden fließenden Ströme proportional zu Entfernungen von dem Finger zu den vier Ecken sind, so dass eine Position eines Berührpunkts des Fingers durch Berechnen von Verhältnissen der Ströme ermittelt wird;
wobei der kapazitive Tastensensor (22) auf eine kompakte Weise ohne Überlappen des Fingerabdruckidentifizierungssensors (21) nahe an dem Fingerabdruckidentifizierungssensor (21) angeordnet ist und der kapazitive Tastensensor (22) auf einer oder mehreren Seiten des Fingerabdruckidentifizierungssensors (21) liegt oder den Fingerabdruckidentifizierungssensor (21) umgibt;
wobei, wenn ein Berührungsvorgang auf einen voreingestellten Berührbereich des Deckglases (23) aufgebracht wird, wobei der voreingestellte Berührbereich mindestens einen Teil des Fingerabdruckidentifizierungssensors (21) und mindestens einen Teil des kapazitiven Tastensensors (22) unter dem voreingestellten Berührbereich bedeckt, der Fingerabdruckidentifizierungssensor (21) und der kapazitive Tastensensor (22) die Fingerabdruckinformationen und die Tasteninformationen erfassen.

2. Vorrichtung nach Anspruch 1, wobei sowohl der Fingerabdruckidentifizierungssensor (21) als auch der kapazitive Tastensensor (22) unter dem voreingestellten Berührbereich des Deckglases (23) liegen.

3. Endgerätvorrichtung, die eine Vorrichtung zur Realisierung einer Berührtaste und einer Fingerabdruckidentifizierung nach einem der Ansprüche 1 bis 2 beinhaltet.

4. Verfahren zur Realisierung einer Berührtaste und einer Fingerabdruckidentifizierung, die Folgendes beinhaltet:
Empfangen (S601) eines Berührungsvorgangs, der auf einem voreingestellten Berührbereich eines Deckglases eines Berührbildschirms durchgeführt wird, wobei der voreingestellte Berührbereich mindestens einen Teil des Fingerabdruckidentifizierungssensors (21) und mindestens einen Teil des kapazitiven Tastensensors (22) unter dem voreingestellten Berührbereich bedeckt, wobei der Fingerabdruckidentifizierungssensor zum Erfassen von auf das Deckglas aufgebrachten Fingerabdruckinformationen konfiguriert ist, der kapazitive Tastensensor (22) auf eine kompakte Weise ohne Überlappen des Fingerabdruckidentifizierungssensors (21) nahe an dem Fingerabdruckidentifizierungssensor (21) angeordnet ist und der kapazitive Tastensensor (22) auf einer oder mehreren Seiten des Fingerabdruckidentifizierungssensors (21) liegt oder den Fingerabdruckidentifizierungssensor (21) umgibt; und
Erfassen (S602) von auf den voreingestellten Berührbereich aufgebrachten Fingerabdruckinformationen; und Erfassen einer zwischen einem Finger eines Benutzers und einer Oberfläche des Berührbildschirms gebildeten Kopplungskapazität und Erfassen von auf das Deckglas (23) aufgebrachten Tasteninformationen auf Basis der Kopplungskapazität; wobei die Kopplungskapazität durch vier Elektroden an vier Ecken des Berührbildschirms fließende Ströme verursacht, wobei die durch die vier Elektroden fließenden Ströme proportional zu Entfernungen von dem Finger zu den vier Ecken sind, so dass eine Position eines Berührpunkts des Fingers durch Berechnen von Verhältnissen der Ströme ermittelt wird;
wobei das Erfassen durch den Fingerabdruckidentifizierungssensor und das Erfassen durch den kapazitiven Tastensensor durchgeführt werden.

5. Verfahren nach Anspruch 4, wobei das Erfassen (S602) von auf den voreingestellten Berührbereich aufgebrachten Fingerabdruckinformationen; und/oder das Erfassen einer auf dem Deckglas erzeugten Kapazität und das Analysieren der Kapazität zum Ermitteln einer Kapazitätsänderung Folgendes beinhalten:
Erfassen (S701) der auf den voreingestellten Berührbereich aufgebrachten Fingerabdruckinformationen, wenn eine übergeordnete Anwendung eine Fingerabdruckinformationserfassungsanweisung aussendet;
Erfassen (S702) der auf dem Deckglas erzeugten Kapazität und Analysieren der Kapazität zum Ermitteln der Kapazitätsänderung, wenn die Benutzeranwendung eine Tasteninformationserfassungsanweisung aussendet;
Erfassen (S703) der auf den voreingestellten Berührbereich aufgebrachten Fingerabdruckinformationen und Erfassen der auf dem Deckglas erzeugten Kapazität und Analysieren der Kapazität zum Ermitteln der Kapazitätsänderung, wenn die übergeordnete Anwendung die Fingerabdruckinformationserfassungsanweisung und die Tasteninformationserfassungsanweisung aussendet.

6. Vorrichtung zur Realisierung einer Berührtaste und einer Fingerabdruckidentifizierung, die Folgendes beinhaltet:
einen Prozessor; und
einen Speicher zum Speichern von durch den Prozessor ausführbaren Anweisungen;
wobei der Prozessor konfiguriert ist zum:
Empfangen (S601) eines Berührungsvorgangs, der auf einem voreingestellten Berührbereich eines Deckglases eines Berührbildschirms durchgeführt wird, wobei der voreingestellte Berührbereich mindestens einen Teil des Fingerabdruckidentifizierungssensors (21) und mindestens einen Teil des kapazitiven Tastensensors (22) unter dem voreingestellten Berührbereich bedeckt, wobei die Fingerabdruckidentifizierung zum Erfassen von auf das Deckglas aufgebrachten Fingerabdruckinformationen konfiguriert ist, der kapazitive Tastensensor (22) auf eine kompakte Weise ohne Überlappen des Fingerabdruckidentifizierungssensors (21) nahe an dem Fingerabdruckidentifizierungssensor (21) angeordnet ist und der kapazitive Tastensensor (22) auf einer oder mehreren Seiten des Fingerabdruckidentifizierungssensors (21) liegt oder den Fingerabdruckidentifizierungssensor (21) umgibt; und
Erfassen (S602) von auf den voreingestellten Berührbereich aufgebrachten Fingerabdruckinformationen; und Erfassen einer zwischen einem Finger eines Benutzers und einer Oberfläche des Berührbildschirms gebildeten Kopplungskapazität und Erfassen von auf das Deckglas (23) aufgebrachten Tasteninformationen auf Basis der Kopplungskapazität; wobei die Kopplungskapazität durch vier Elektroden an vier Ecken des Berührbildschirms fließende Ströme veranlasst, wobei die durch die vier Elektroden fließenden Ströme proportional zu Entfernungen von dem Finger zu den vier Ecken sind, so dass eine Position eines Berührpunkts des Fingers durch Berechnen von Verhältnissen der Ströme ermittelt wird;
wobei das Erfassen durch den Fingerabdruckidentifizierungssensor und das Erfassen durch den kapazitiven Tastensensor durchgeführt werden.

7. Nichtflüchtiges computerlesbares Speichermedium, das bei Ausführung durch einen Prozessor eines Mobil-Endgeräts das Mobil-Endgerät zum Ausführen eines Verfahrens zur Realisierung einer Berührtaste und einer Fingerabdruckidentifizierung nach Anspruch 4 oder 5 veranlasst.

## Revendications

1. Dispositif pour réaliser un bouton tactile et une identification d'empreintes digitales intégrés, comprenant :
un capteur d'identification d'empreintes digitales (21), disposé sous un verre de recouvrement (23) d'un écran tactile d'un dispositif terminal, le capteur d'identification d'empreintes digitales étant configuré pour recueillir des informations des empreintes digitales appliquées au verre de recouvrement ; et
un capteur de bouton capacitif (22) disposé sous le verre de recouvrement (23) et situé sur au moins un côté du capteur d'identification d'empreintes digitales (21), le capteur de bouton capacitif étant configuré pour recueillir des informations du bouton appliquées au verre de recouvrement (23) sur la base d'une capacité de couplage formée entre un doigt d'un utilisateur et une surface de l'écran tactile, dans lequel la capacité de couplage fait que des courants coulent à travers quatre électrodes aux quatre coins de l'écran tactile, les courants coulant à travers les quatre électrodes étant proportionnels aux distances du doigt aux quatre coins, de sorte qu'un emplacement d'un point d'effleurement du doigt est obtenu en calculant les rapports des courants ;
dans lequel le capteur de bouton capacitif (22) est disposé près du capteur d'identification d'empreintes digitales (21) de manière compacte sans chevaucher le capteur d'identification d'empreintes digitales (21), et le capteur de bouton capacitif (22) est situé sur un ou plusieurs côtés du capteur d'identification d'empreintes digitales (21) ou encercle le capteur d'identification d'empreintes digitales (21) ;
dans lequel une opération d'effleurement est appliquée à une zone d'effleurement préréglée du verre de recouvrement (23), la zone d'effleurement préréglée couvrant au moins une partie du capteur d'identification d'empreintes digitales (21) et au moins une partie du capteur de bouton capacitif (22) sous la zone d'effleurement préréglée, le capteur d'identification d'empreintes digitales (21) et le capteur de bouton capacitif (22) recueillent les informations d'empreintes digitales et les informations du bouton.

2. Dispositif selon la revendication 1, dans lequel le capteur d'identification d'empreintes digitales (21) et le capteur de bouton capacitif (22) sont situés tous les deux sous la zone d'effleurement préréglée du verre de recouvrement (23).

3. Dispositif terminal, comprenant un dispositif pour réaliser un bouton tactile et une identification d'empreintes digitales selon l'une quelconque des revendications 1-2.

4. Procédé pour réaliser un bouton tactile et une identification d'empreintes digitales, comprenant :
recevoir (S601) une opération d'effleurement effectuée sur une zone d'effleurement préréglée d'un verre de recouvrement d'un écran tactile, la zone d'effleurement préréglée couvrant au moins une partie du capteur d'identification d'empreintes digitales (21) et au moins une partie du capteur de bouton capacitif (22) sous la zone d'effleurement préréglée, dans lequel le capteur d'identification d'empreintes digitales est configuré pour recueillir des informations d'empreintes digitales appliquées au verre de recouvrement, le capteur de bouton capacitif (22) est disposé près du capteur d'identification d'empreintes digitales (21) de manière compacte sans chevaucher le capteur d'identification d'empreintes digitales (21), et le capteur de bouton capacitif (22) est situé sur un ou plusieurs côtés du capteur d'identification d'empreintes digitales (21) ou encercle le capteur d'identification d'empreintes digitales (21) ; et
recueillir (S602) des informations d'empreintes digitales appliquées à la zone d'effleurement préréglée, et recueillir une capacité de couplage formée entre un doigt d'un utilisateur et une surface de l'écran tactile et recueillir des informations du bouton appliquées au verre de recouvrement (23) sur la base de la capacité de couplage ; dans lequel la capacité de couplage fait que des courants coulent à travers quatre électrodes aux quatre coins de l'écran tactile, les courants coulant à travers les quatre électrodes étant proportionnels aux distances du doigt aux quatre coins, de sorte qu'un emplacement d'un point d'effleurement du doigt est obtenu en calculant les rapports des courants ;
dans lequel la collecte par le capteur d'identification d'empreintes digitales et la collecte par le capteur de bouton capacitif sont effectuées.

5. Procédé selon la revendication 4, dans lequel recueillir (S602) les informations d'empreintes digitales appliquées à la zone d'effleurement préréglée, et/ou recueillir une capacité générée sur le verre de recouvrement et analyser la capacité pour obtenir une variation de capacité comprend :
recueillir (S701) les informations d'empreintes digitales appliquées à la zone d'effleurement préréglée, si une application supérieure envoie une instruction de collecte d'informations d'empreintes digitales ;
recueillir (S702) la capacité générée sur le verre de recouvrement et analyser la capacité pour obtenir une variation de capacité, si l'application supérieure envoie une instruction de collecte d'informations de bouton ;
recueillir (S703) les informations d'empreintes digitales appliquées à la zone d'effleurement préréglée, et recueillir la capacité générée sur le verre de recouvrement et analyser la capacité pour obtenir la variation de capacité, si l'application supérieure envoie l'instruction de recueillir les informations d'empreintes digitales et l'instruction de recueillir les informations de bouton.

6. Dispositif pour réaliser un bouton tactile et une identification d'empreintes digitales, comprenant :
un processeur ; et
une mémoire pour stocker des instructions exécutables par le processeur ;
dans lequel le processeur est configuré pour :
recevoir (S601) une opération d'effleurement effectuée sur une zone d'effleurement préréglée d'un verre de recouvrement d'un écran tactile, la zone d'effleurement préréglée couvrant au moins une partie du capteur d'identification d'empreintes digitales (21) et au moins une partie du capteur de bouton capacitif (22) sous la zone d'effleurement préréglée, dans lequel le capteur d'identification d'empreintes digitales est configuré pour recueillir des informations d'empreintes digitales appliquées au verre de recouvrement, le capteur de bouton capacitif (22) est disposé près du capteur d'identification d'empreintes digitales (21) de manière compacte sans chevaucher le capteur d'identification d'empreintes digitales (21), et le capteur de bouton capacitif (22) est situé sur un ou plusieurs côtés du capteur d'identification d'empreintes digitales (21) ou encercle le capteur d'identification d'empreintes digitales (21) ; et
recueillir (S602) des informations d'empreintes digitales appliquées à la zone d'effleurement préréglée, et recueillir une capacité de couplage formée entre un doigt d'un utilisateur et une surface de l'écran tactile et recueillir des informations du bouton appliquées au verre de recouvrement (23) sur la base de la capacité de couplage ; dans lequel la capacité de couplage fait que des courants coulent à travers quatre électrodes aux quatre coins de l'écran tactile, les courants coulant à travers les quatre électrodes étant proportionnels aux distances du doigt aux quatre coins, de sorte qu'un emplacement d'un point d'effleurement du doigt est obtenu en calculant les rapports des courants ;
dans lequel la collecte par le capteur d'identification d'empreintes digitales et la collecte par le capteur de bouton capacitif sont effectuées.

7. Support de stockage non transitoire lisible par ordinateur, lorsque exécuté par un processeur d'un terminal mobile, fait que le terminal mobile exécute un procédé pour réaliser un bouton tactile et une identification d'empreintes digitales selon la revendication 4 ou 5.
